(19) Europäisches Patentamt

European Patent Office

Office européen des brevets

(11) **EP 0 864 875 B1**

(12) **EUROPÄISCHE PATENTSCHRIFT**

(45) Veröffentlichungstag und Bekanntmachung des Hinweises auf die Patenterteilung:
**20.08.2003 Patentblatt 2003/34**

(51) Int Cl.[7]: **G01R 31/327**, G01R 31/02, G05B 19/042

(21) Anmeldenummer: **97106504.0**

(22) Anmeldetag: **19.04.1997**

(54) **Verfahren zur Überprüfung einer Sicherheitsschaltung**

Method for testing a safety circuit

Procédé pour tester un circuit de sécurité

(84) Benannte Vertragsstaaten:
**DE FR GB IT**

(30) Priorität: **11.03.1997 DE 97104039**

(43) Veröffentlichungstag der Anmeldung:
**16.09.1998 Patentblatt 1998/38**

(73) Patentinhaber: **SCHNEIDER ELECTRIC GMBH**
**40880 Ratingen (DE)**

(72) Erfinder: **Auger, Marc**
**16800 Soyaux (FR)**

(74) Vertreter: **Wanischeck-Bergmann, Axel, Dipl.-Ing.**
**Rondorfer Strasse 5a**
**50968 Köln (DE)**

(56) Entgegenhaltungen:
| | |
|---|---|
| EP-A- 0 418 665 | EP-A- 0 762 246 |
| WO-A-92/17829 | US-A- 4 275 464 |
| US-A- 4 390 920 | US-A- 4 627 056 |

**Beschreibung**

Die Erfindung betrifft ein Verfahren zur Überprüfung einer Sicherheitsschaltung für elektrische Maschinen, insbesondere Pressen oder dergleichen auf eventuelle Kurzschlüsse und/oder Fehler, mit zumindest einem Kontrollausgang und zumindest einem Eingang, wobei die Anzahl der Eingänge von der Anzahl der Kontrollausgänge abweicht, und jeder Kontrollausgang ein Ausgangssignal abgibt, welche Ausgangssignale den Eingängen als Eingangssignale zugeleitet werden, und jedes Ausgangssignal zur Überprüfung eines möglichen Kurzschlusses genutzt wird.

Aus der Praxis und aus dem Stand der Technik sind Sicherheitsschaltungen in verschiedenen Ausführungen bekannt, und zwar im Zusammenhang mit elektrischen Einrichtungen oder Maschinen, bei denen im eingeschalteten Zustand für die Bedienungsperson gefährliche Bedingungen, insbesondere gefährliche Maschinenbewegungen herrschen. Zum Einschalten des jeweils gefährlichen Zustandes dient hierbei eine Zweihandbetätigung, wodurch sichergestellt werden soll, daß die beiden Hände der bedienenden Person beschäftigt sind und jede Möglichkeit ausgeschlossen ist, etwa mit der einen oder anderen Hand in den Gefahr bringenden Raum einzugreifen. Gleichzeitig soll sichergestellt sein, daß sich die bedienende Person oder deren Beine an einem Platz befinden, an dem keine Gefahr während der gefährlichen Bewegung auf die bedienende Person entsteht. In diesem Zusammenhang soll auch bei den bekannten Sicherheitsschaltungen angestrebt werden, daß jegliche Manipulationen an der Zweihandbetätigung ausgeschlossen ist. Ferner wird angestrebt, daß die elektrische Sicherheitsschaltung fehlerfrei arbeitet, so daß nur dann ein Durchschalten an den Verbraucher, d. h. ein Einschalten des gefährlichen Betriebszustandes möglich ist, daß aber andererseits bei Auftreten irgendeines Fehlers innerhalb der Schaltung mit Sicherheit ein Durchschalten unterbunden wird.

Zur Überprüfung derartiger Sicherheitsschaltungen ist es aus dem Stand der Technik bekannt, daß Kurzschlüsse zwischen den verschiedenen Eingängen geprüft und erkannt werden. Hierzu stehen drei unterschiedliche Sicherheitseingabesignale zur Verfügung. Zum einen handelt es sich hierbei um einzelne Eingabesignale, beispielsweise Rückkopplungseingaben, mit Zweistellungsschaltern verbundene Eingaben oder dergleichen, andererseits können derartige Sicherheitseingabesignale komplementäre Eingangssignale, beispielsweise solche Eingangssignale sein, die mit einem geführten NO- und NC-Kontakt verbundene Schalteinrichtungen verbunden sind. Schließlich sind noch selektive Eingangssignale bekannt, die einem Funktionsselektor (Wahlschalter) aufgegeben werden.

Jedes einzelne Eingangssignal wird durch einen separaten Kontrollausgang erzeugt. Komplementäre Eingangssignale, die einem gemeinsamen Schalter aufgegeben werden, werden durch einen gemeinsamen Kontrollausgang erzeugt. In gleicher Weise werden die wählbaren Eingangssignale für einen gemeinsamen Wahlschalter gleichfalls durch einen gemeinsamen Kontrollausgang erzeugt.

Hierbei verwenden sämtliche Kontrollausgangsschnittstellen eine Seitentreibertechnologie, d. h. einen Treiber mit einem an +24V angeschlossenen Schaltelement. Die Seitentreibertechnologie verhindert einen Überstrom, der zwischen den Schaltelementen im Falle eines Kurzschlusses zwischen zwei Ausgängen fließen kann. Ferner ermöglicht die Seitentreibertechnologie das Erkennen eines Kurzschlusses zwischen zwei Ausgängen, wenn die Stellung der Kontrollausgänge erkannt und mit einer erwarteten Normalstellung verglichen wird. Es besteht ferner die Möglichkeit, einen sogenannten Low side driver zu verwenden.

Zur Überprüfung derartiger Sicherheitsschaltungen ist ein sogenannter sequentieller Test bekannt, der die einzelnen Eingangssignale nacheinander überprüft. Hierzu sind die einzelnen Eingangssignale generell an einem Zweistellungsschalter oder einer Rückkopplungsschleife angeschlossen. Jeder Eingang wird von einem separaten Kontrollausgang versorgt. Bei diesem vorbekannten sequentiellen Test werden die Kontrollausgänge in einzelnen Phasen geprüft, wobei die Anzahl der Phasen mit der Anzahl der Kontrollausgänge übereinstimmt. Während jeder Phase wird lediglich ein Kontrollausgang aktiviert, so daß am Ende jeder Phase sämtliche Eingangssignale gleichzeitig erfaßt werden müssen. Liegt bei geschlossenem Schalter kein Kurzschluß vor, wird lediglich der von dem aktivierten Kontrollausgang angesteuerte Eingang auf ein Niveau 1 geschaltet. Ein Kurzschluß wird dann erkannt, wenn mehr als ein Eingang auf das Niveau 1 geschaltet ist oder wenn ein Eingang auf das Niveau 1 geschaltet ist, welcher Eingang jedoch nicht mit dem aktivierten Kontrollausgang korrespondiert.

Aus den voranstehenden Ausführungen ergibt sich der wesentliche Nachteil dieser vorbekannten Vorgehensweise dahingehend, daß insbesondere bei Sicherheitsschaltungen mit einer großen Anzahl von Eingängen und Ausgängen ein relativ langer Zeitraum zur Überprüfung sämtlicher Kurzschlußmöglichkeiten notwendig ist.

Aus der US 4 627 056 A1 ist ein Überprüfungssystem für ein Steuerungspaneel mit einem Mikrocomputer bekannt, das eine Überprüfungseinheit aufweist, die durch ein Prüfprogramm des Mikrocomputers aktivierbar ist. Zu jeder Zeit werden Linienwechselsignale erzeugt und alle Eingangssignale der betreffenden Eingangsverbindungen mit Ausnahme der festgesetzten Verbindung geprüft, um Prüfausgangssignale zu generieren, die den Eingangssignalen in der Eingangsleitungsprüfung entsprechen. Die entsprechenden Ausgangsverbindungen des Steuerungspaneels werden mit Ausnahme einer bestimmten Verbindung in der Folge in einer Ausgangslinienprüfung aktiv gehalten.

Das Überprüfungssystem erkennt demnach abweichende Zustände zwischen den Ausgängen des Mikrocomputers und den Verbindungen des Steuerungspaneels.

2

Femer ist aus der EP 0 418 665 A1 eine Vorrichtung zur Erkennung und Eliminierung von funktionalen Fehlern in einer elektrischen Energiequelle bekannt. Diese Vorrichtung besteht aus einem Steuerschaltkreis mit einem Transistor zur Steuerung der Energieübertragung auf eine Kapazität, mehreren Detektoren und einem Logikschaltkreis, der über zwei Leitungen mit einem Computer verbunden ist. Dieser Computer steuert über bestimmte Kombinationen von logischen Signalen aus den Leitungen verschiedene logische Unterschaltkreise für die Erkennung und Identifikation von funktionalen Fehlem in der Energiequelle der Kapazität. Der Steuerschaltkreis überträgt im Gegenzug über die Leitungen logische Signale entsprechend dem Vorhandensein oder dem Fehlen von Fehlern in bestimmten Zeitintervallen, in denen der Computer zur Erkennung dieser Signale bereit ist. Anwendung findet diese Vorrichtung bei Elektroventilen von Antiblockiersystemen von Fahrzeugen.

Schließlich offenbart die US 4 275 464 A1 eine Mikroprozessor gestützte elektronische Steuerungseinrichtung mit einer Möglichkeit zur Selbstdiagnose von Fehlern.

Ausgehend von diesem Stand der Technik liegt der Erfindung die **Aufgabe** zugrunde, ein gattungsgemäßes Verfahren derart weiterzubilden, daß eine vollständige Überprüfung einer Sicherheitsschaltung in einfacher Weise und insbesondere in kurzer Zeit durchführbar ist.

Die **Lösung** dieser Aufgabenstellung sieht vor, daß mehrere, zumindest zwei Ausgangssignale parallel, d. h. im wesentlichen gleichzeitig während einer Phase hinsichtlich der Prüfung eines möglichen Kurzschlusses zwischen zwei Eingängen genutzt werden und daß die Gesamtzahl der Ausgangssignale in mehreren, nacheinander ablaufenden Phasen geprüft werden, wobei jede Phase der Prüfung mehrerer, zumindest zweier Ausgangssignale und / oder Eingangssignale dient.

Demzufolge werden bei einem erfindungsgemäßen Verfahren mehr als ein Kontrollausgang zur gleichen Zeit aktiviert. Die Überprüfung der Kontrollausgänge und eventueller Kurzschlüsse zwischen den Eingängen wird ebenfalls phasenweise durchgeführt, wobei jedoch in jeder Phase eine Vielzahl von Ausgangssignalen und Eingangssignalen gleichzeitig geprüft wird, so daß die für die gesamte Überprüfung benötigte Zeit wesentlich verkürzt werden kann.

Nach einem weiteren Merkmal der Erfindung ist vorgesehen, daß jedem Ausgangssignal ein Binär-Code zugewiesen wird. Dadurch läßt sich in besonderer Weise eine zuverlässige und eindeutige Anzeige der ermittelten Kurzschlüsse während jeder Phase erzielen. Darüber hinaus handelt es sich um eine sehr einfache Vorgehensweise, um das erfindungsgemäße Verfahren durchzuführen. Beispielsweise wird dem ersten Kontrollausgang der Code 01 und jedem weiteren Kontrollausgang eine höhere Nummer, in Abhängigkeit der Anzahl der Kontrollausgänge, zugeordnet.

Vorzugsweise wird die Anzahl der Phasen in Abhängigkeit der Ausgangs- bzw. Eingangssignale nach der Formel

$$N \geq \frac{\mathrm{Log}N_{co}}{\mathrm{Log}2}$$

gesteuert, wobei $N_{CO}$ die Anzahl der Kontrollausgänge angibt und die Kontrollausgänge nicht geprüft werden. Sollen die Kontrollausgänge geprüft werden, so ist der Nenner in der voranstehenden Formel zu ersetzen durch $\mathrm{Log}(N_{CO}+2)$.

Hierdurch werden beispielsweise bei vier Kontrollausgängen sechs mögliche Kurzschlüsse in zwei Testphasen geprüft, wobei in drei Testphasen ein zusätzlicher und gleichzeitig ablaufender Test aller Kontrollausgänge möglich ist. Bei acht Kontrollausgängen beträgt die Anzahl der möglichen Kurzschlüsse bereits 28, so daß drei Testphasen zur Überprüfung notwendig sind und in vier Testphasen sämtliche Kontrollausgänge zusätzlich und gleichzeitig überprüft werden können. Eine Verdoppelung der Kontrollausgänge auf 16 führt zu 120 möglichen Kurzschlüssen, die in vier Testphasen überprüft werden können, wobei auch hier ein zusätzlicher und gleichzeitig ablaufender Test aller Kontrollausgänge eine zusätzliche Testphase, d. h. insgesamt fünf Testphasen erfordert.

Nach einem weiteren Merkmal der Erfindung ist vorgesehen, daß die Sicherheitsschaltung zur Abschaltung eines Verbrauchers aktiviert wird, wenn während zumindest einer Phase zumindest ein Kurzschluß erkannt wird. Weiterhin ist nach einem ergänzenden Merkmal der Erfindung vorgesehen, daß bei Erkennen eines Kurzschlusses die Überprüfung eventueller Kurzschlüsse in der Sicherheitsschaltung vollständig neu durchgeführt wird. Diese Vorgehensweise ist mit dem erfindungsgemäßen Verfahren insbesondere dadurch in vorteilhafter Weise durchführbar, daß durch die parallele Überprüfung mehrerer Kontrollausgänge und Eingänge eine beschleunigte Prüfung der Sicherheitsschaltung möglich ist. Für den Fall des Vorliegens eines Kurzschlusses muß der angeschlossene Verbraucher abgeschaltet werden und der Mikroprozessor eine vollständig neue Überprüfung, d. h. beispielsweise vier Phasen der Überprüfung durchführen. Nach jeder Phase können bestimmte Kombinationen elimiert werden, die zweifelsfrei keinen Kurzschluß aufweisen, so daß nach Abschluß sämtlicher Phasen der Kurzschluß exakt lokalisiert werden kann.

Demzufolge besteht ein weiteres Merkmal der Erfindung darin, daß nach jeder Phase der erneuten Überprüfung eventueller Kurzschlüsse in der Sicherheitsschaltung die Ausgangssignale eliminiert werden, die keinen Kurzschluß anzeigen.

Nach einem weiteren Merkmal der Erfindung ist vorgesehen, daß die Überprüfung eventueller Kurzschlüsse und / oder Fehler in mehrere, zumindest zwei Abschnitte geteilt ist, wobei der zweite Abschnitt mehrere Phasen zur Prüfung der Kurzschlüsse aufweist und im ersten Abschnitt die Ausgangssignale bzw. Eingangssignale gelesen und geprüft werden. Diese Vorgehensweise beschleunigt das erfindungsgemäße Verfahren für den Fall, daß eine unzutreffende Fehlerdiagnose der Sicherheitsschaltung erstellt wird. Es hat sich nämlich gezeigt, daß auch dann Kurzschlüsse ermittelt werden können, wenn ein wahrer Kurzschluß nicht vorliegt, da bereits beim Lesen der Eingangssignale Fehler auftreten können, die einen Kurzschluß signalisieren oder ein Schalter eines Schalters im Zeitpunkt des Schalters ein Kurzschluß angenommen wird.

Eine Weiterbildung dieser Ausführungsform sieht vor, daß ein ermittelter Kurzschluß und / oder Fehler in der Sicherheitsschaltung vor Aktivierung eines Abschaltmodus für den angeschlossenen Verbraucher bestätigt wird, wobei ausschließlich die Ausgangssignale erneut abgegeben werden, die fehlerfrei sind. Wird hierbei festgestellt, daß sämtliche Ausgangssignale fehlerfrei sind, kann der elektrische Verbraucher anlaufen, da dann kein wahrer Fehler und / oder Kurzschluß vorgelegen hat.

Beim Erkennen eines fehlerhaften Ausgangs- und / oder Eingangssignals wird nach einem weiteren Merkmal der Erfindung der nachfolgende Abschnitt zum erneuten Lesen und Prüfen der Ausgangs- und / oder Eingangssignale genutzt. Zusätzlich kann vorgesehen sein, daß bei Erkennen eines Kurzschlusses und / oder Fehlers im zweiten Abschnitt ein erneuter erster Abschnitt geschaltet wird, in welchem die Ausgangs- bzw. Eingangssignale gelesen und geprüft werden.

Nach einem weiteren Merkmal der Erfindung ist vorgesehen, daß parallel zur Überprüfung der Kontrollausgangs- bzw. Eingangssignale hinsichtlich eventueller Kurzschlüsse und / oder Fehler auch eine Überprüfung der Eingangsschnittstellen durchgeführt wird.

Schließlich ist nach einem weiteren Merkmal der Erfindung vorgesehen, daß die Überprüfung der Eingangsschnittstellen phasenweise entsprechend der Überprüfung der Eingangs- bzw. Kontrollausgangssignale in den einzelnen Phasen abläuft.

Weitere Merkmale und Vorteile des erfindungsgemäßen Verfahrens ergeben sich aus der nachfolgenden Beschreibung der zugehörigen Zeichnung.

In der Zeichnung zeigt:

Fig. 1 ein Schaltbild einer Eingangsverdrahtung einer Sicherheitsschaltung;

Fig. 2 eine Darstellung der möglichen Kurzschlüsse zwischen den Eingängen der Sicherheitsschaltung gemäß Fig. 1;

Fig. 3 ein vereinfachtes Schaltbild der Sicherheitsschaltung gemäß Fig. 1;

Fig. 4 eine Prinzipsdarstellung des Überprüfungsverfahrens für die Sicherheitsschaltung gemäß Fig. 3;

Fig. 5 ein erster möglicher Kurzschluß in der Sicherheitsschaltung gemäß Fig. 3;

Fig. 6 ein zweiter möglicher Kurzschluß in der Sicherheitsschaltung gemäß Fig. 3;

Fig. 7 ein dritter möglicher Kurzschluß in der Sicherheitsschaltung gemäß Fig. 3;

Fig. 8 ein vierter möglicher Kurzschluß in der Sicherheitsschaltung gemäß Fig. 3;

Fig. 9 ein fünfter möglicher Kurzschluß in der Sicherheitsschaltung gemäß Fig. 3;

Fig. 10 eine ergänzte Sicherheitsschaltung gemäß Fig. 3 in vereinfachter Darstellung;

Fig. 11 eine vereinfachte Darstellung einer Sicherheitsschaltung für komplementäre Eingangssignale;

Fig. 12 eine vereinfachte Darstellung einer Sicherheitsschaltung für selektive Eingangssignale;

Fig. 13 in einer ersten Phase des Überprüfungsverfahrens erkennbare Kurzschlüsse;

Fig. 14 in einer zweiten Phase des Überprüfungsverfahrens erkennbare Kurzschlüsse;

Fig. 15 ein Ablaufdiagramm des Überprüfungsverfahrens in 6 Abschnitten;

Fig. 16 ein Abhängigkeitsdiagramm zwischen der Zeitdauer der Überprüfung und der Anzahl der zu überprüfenden Kontrollausgänge bei einem Verfahren nach dem Stand der Technik;

Fig. 17 das Diagramm gemäß Fig. 16 bei einem erfindungsgemäßen Verfahren;

Fig. 18 ein möglicher Fall einer falschen Diagnose bei einer Sicherheitsschaltung gemäß Fig. 11;

Fig. 19 ein möglicher Fall einer falschen Diagnose bei einer Sicherheitsschaltung gemäß Fig. 12;

Fig. 20 ein Ablaufdiagramm der maximalen Reaktionszeit unter Normalbedingungen;

Fig. 21 ein Zeitablaufdiagramm beim Auftreten von Fehlermeldungen in der Eingangslesephase;

Fig. 22 das Zeitablaufdiagramm gemäß Fig. 21 beim Auftreten eines Fehlers in der Kurzschlußerkennungsphase und

Fig. 23 eine Prinzipskizze einer Sicherheitsschaltung zur Überprüfung eventueller Kurzschlüsse und der Eingangsschnittstellen.

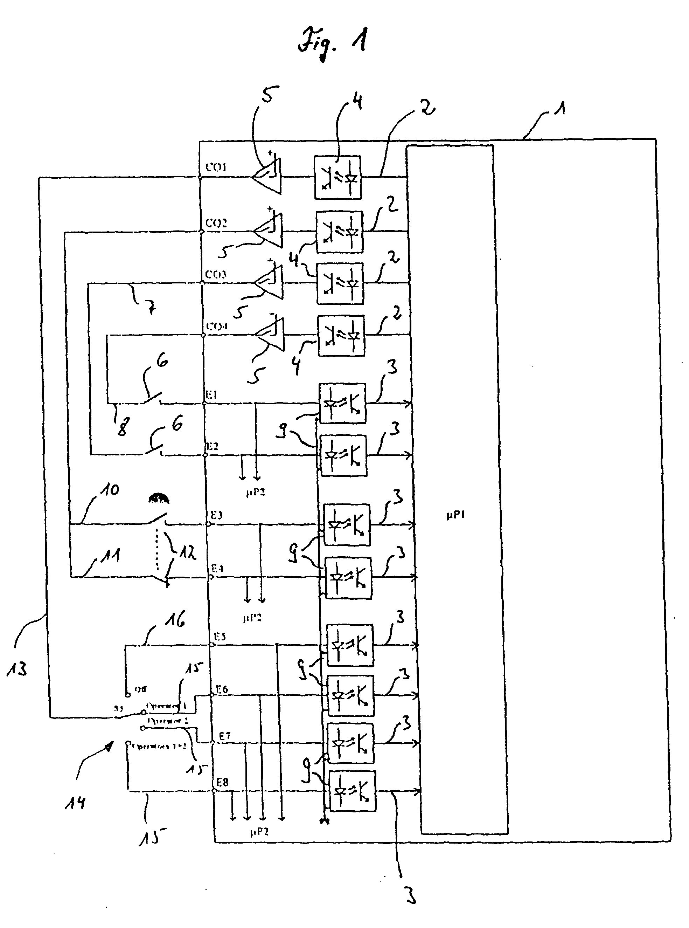

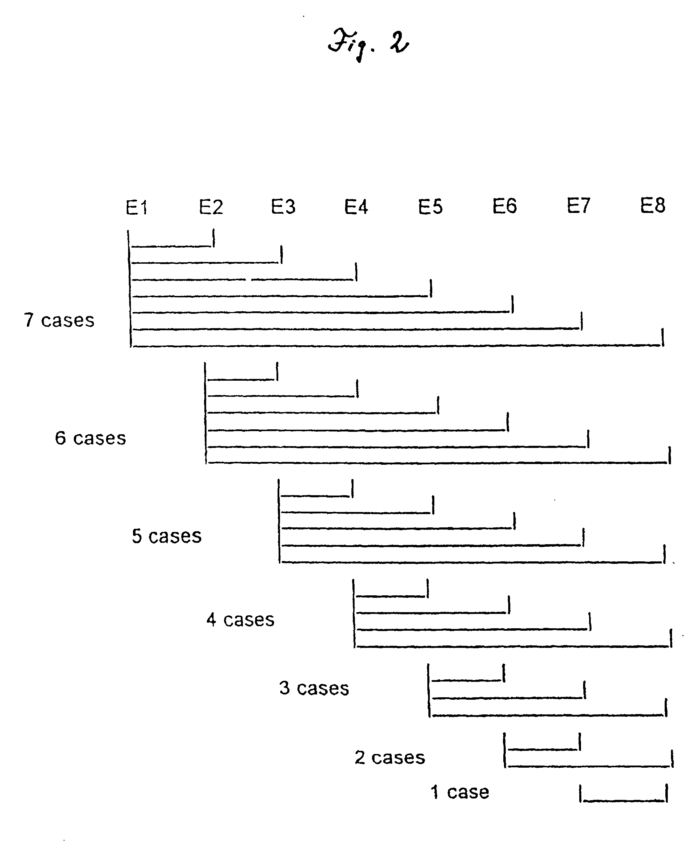

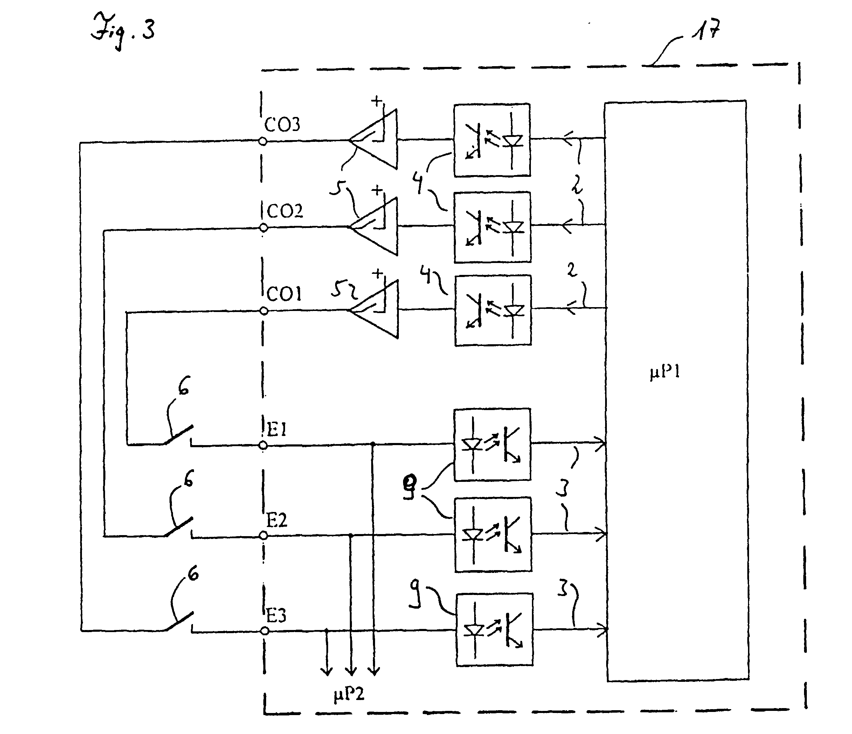

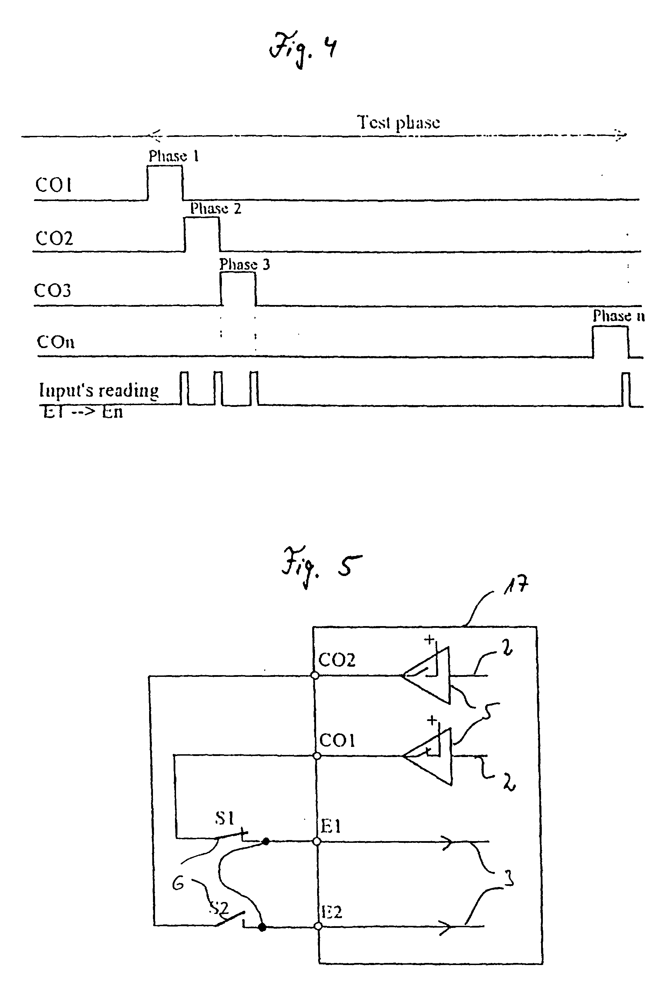

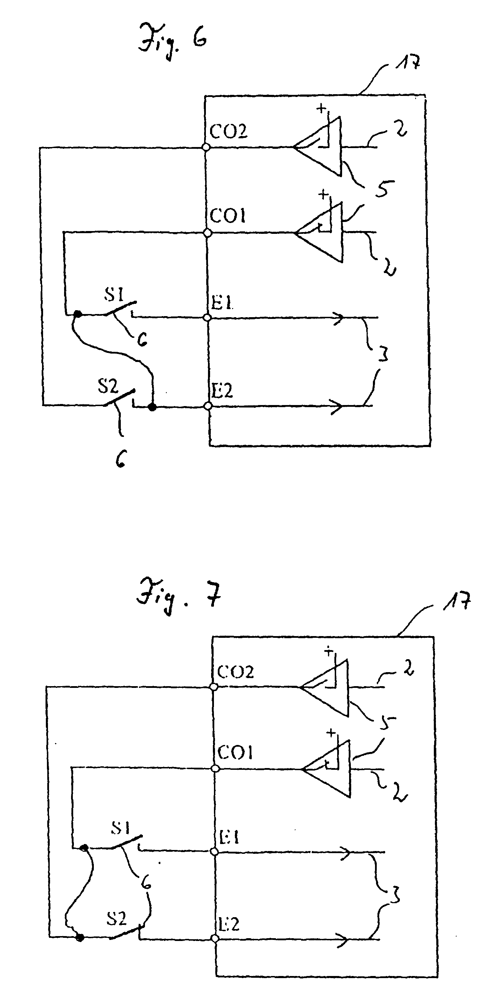

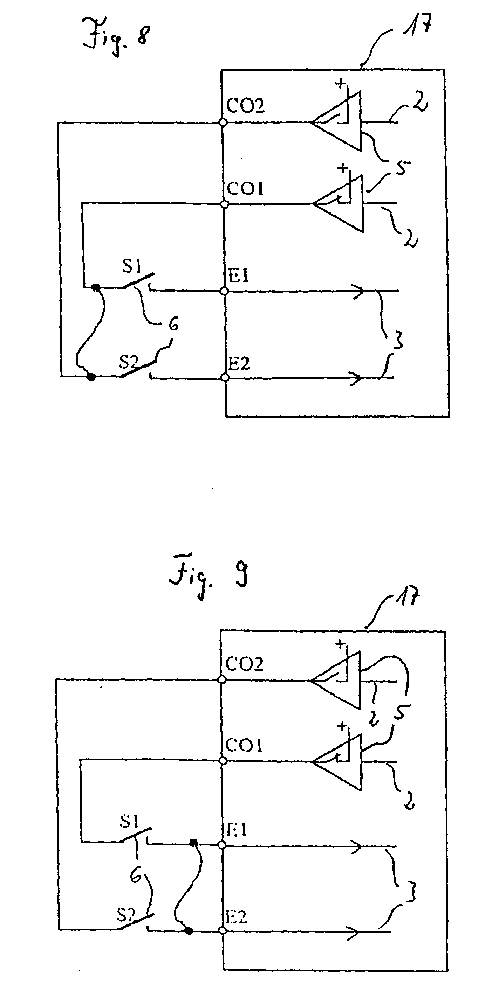

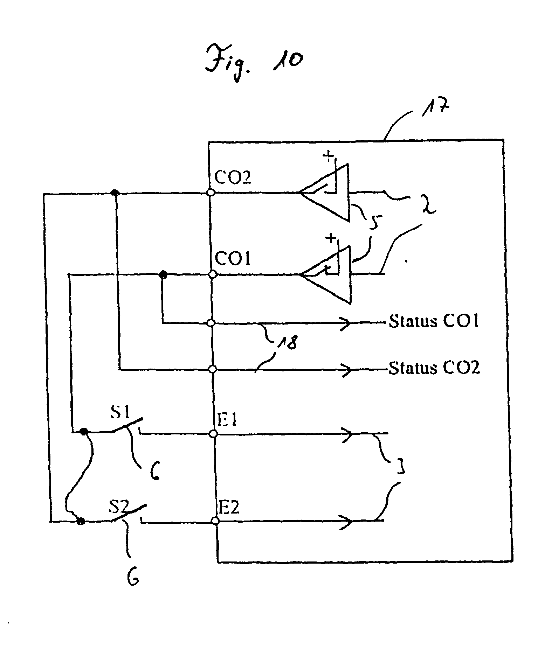

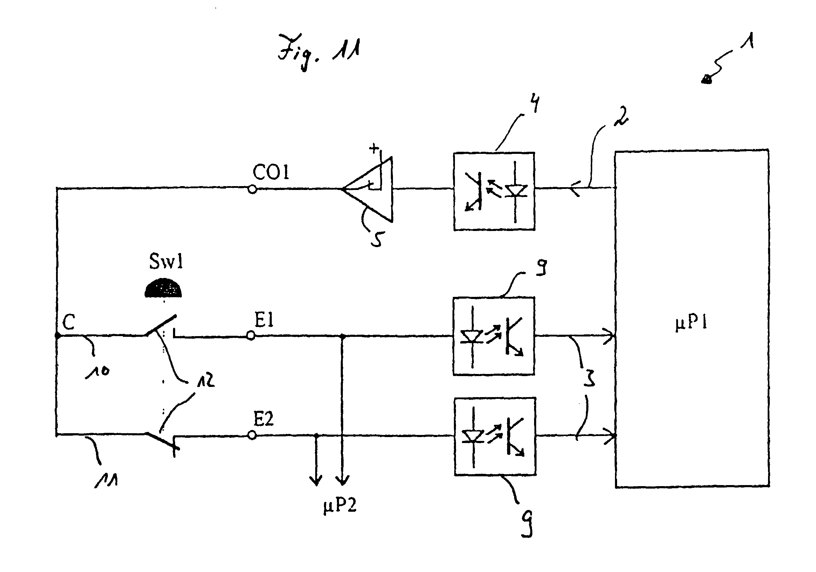

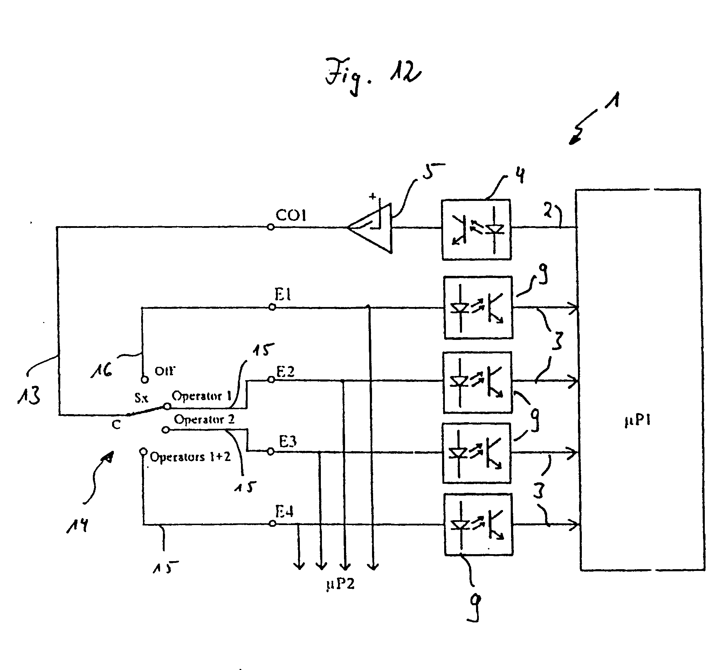

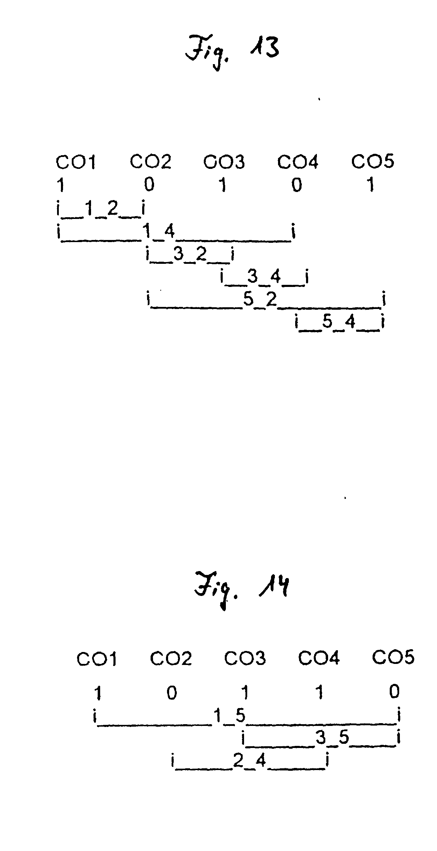

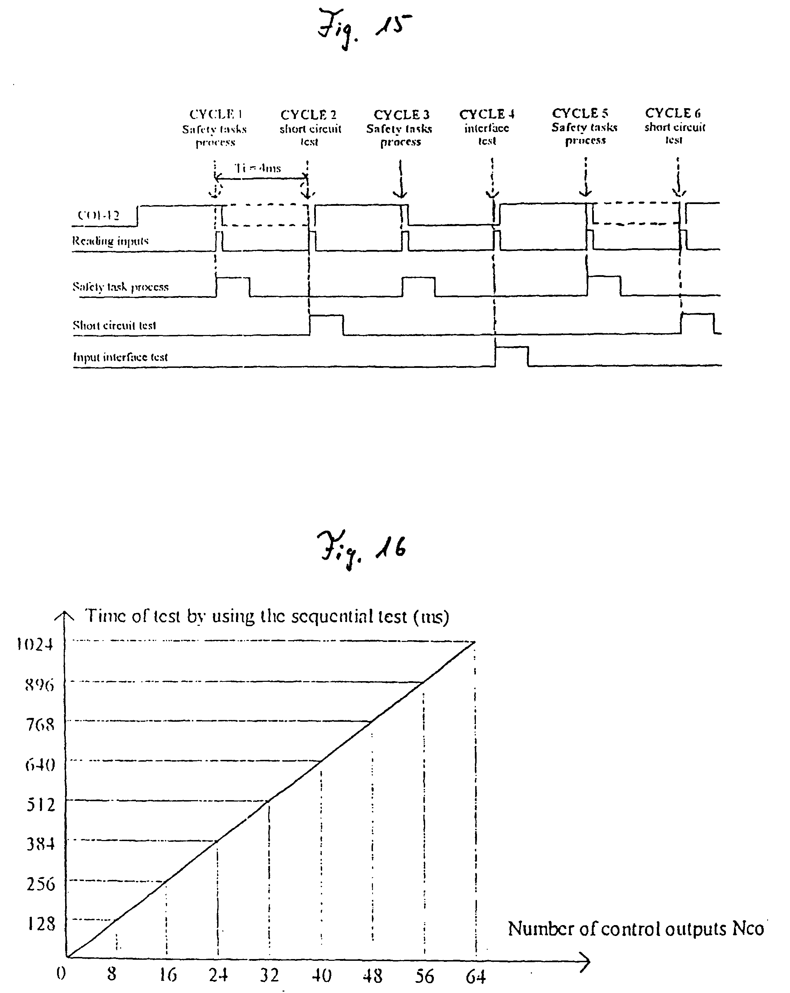

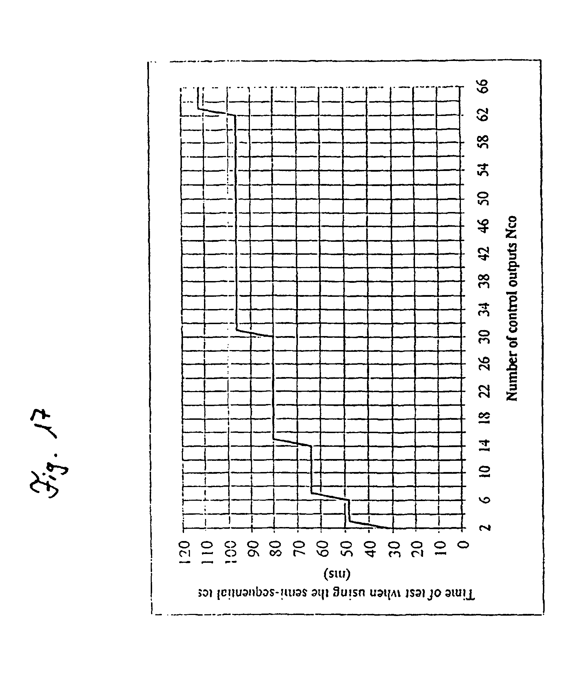

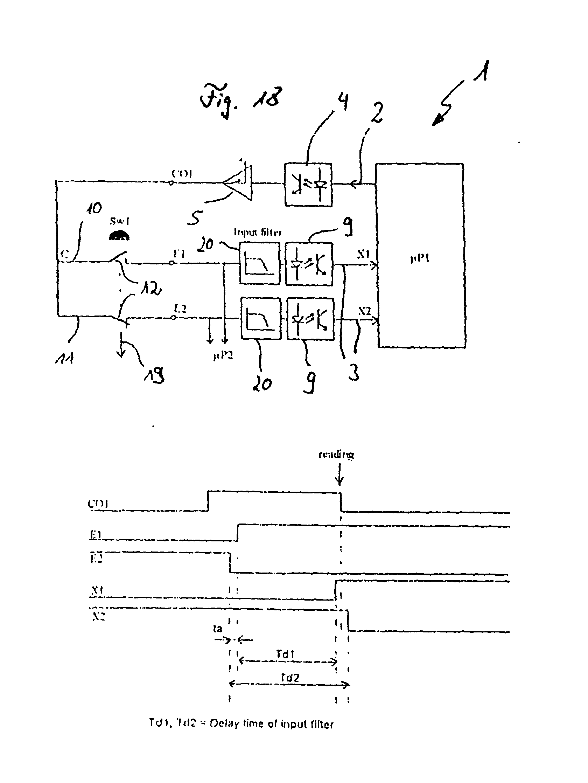

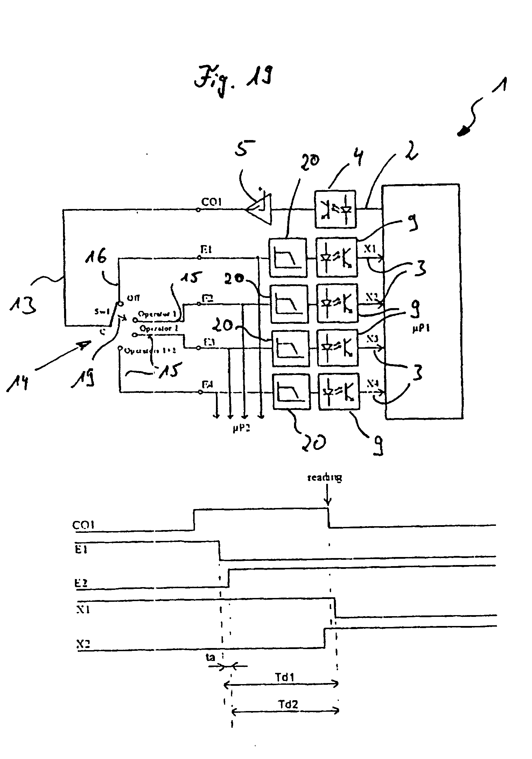

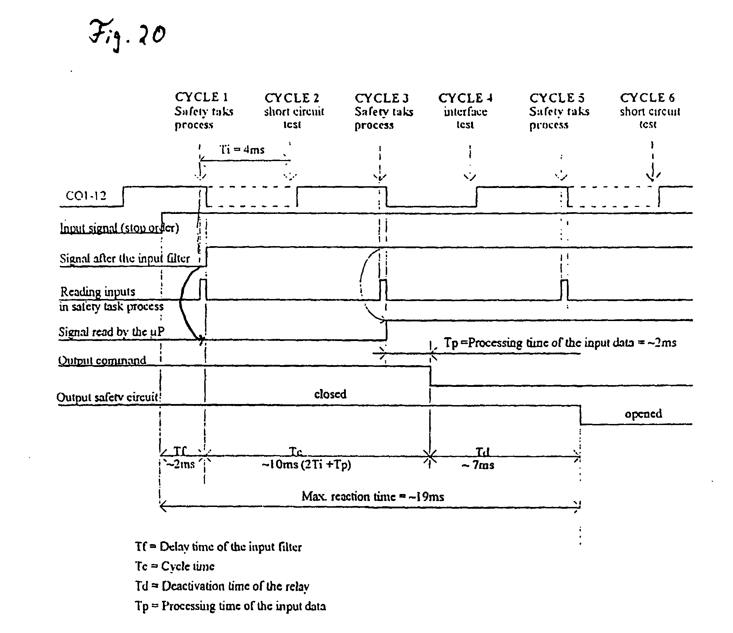

In der Fig. 1 ist eine Sicherheitsschaltung 1 für elektrische Verbraucher, beispielsweise elektrische Maschinen im Schaltbild dargestellt. Diese an sich bekannte Sicherheitsschaltung weist vier Kontrollausgänge 2 auf, die ausgangsseitig mit CO1 bis CO4 bezeichnet sind. Darüberhinaus weist die Sicherheitsschaltung acht Eingänge 3 auf, die eingangsseitig mit E1 bis E8 bezeichnet sind. Jeder Kontrollausgang 2 weist einen Optokoppler 4 sowie einen damit in Reihe geschalteten Treiber 5 mit einem an +24V angeschlossenen Schaltelement auf.

Die Kontrollausgänge 2 mit den Bezeichnungen CO3 und CO4 sind unmittelbar an die Eingänge 3 mit den Bezeichnungen E1 und E2 angeschlossen, wobei jeweils ein Schaltelement 6 (Schließer) in die Verbindungsleitungen 7 und 8 geschaltet ist. Hierbei verbindet die Verbindungsleitung 7 den Kontrollausgang mit der Bezeichnung CO3 mit dem Eingang 3, welcher die Bezeichnung E2 hat. Die Verbindungsleitung 8 verbindet den Kontrollausgang 2 mit der Bezeichnung CO4 mit dem Eingang 3, der die Bezeichnung E1 führt.

Die Eingänge 3 mit den Bezeichnungen E1 und E2 sind als einfache Eingänge, beispielsweise als Rückkopplungseingänge oder als Eingänge mit einem Anschluß an einen Wechselschalter ausgebildet. Weiterhin weisen die Eingänge 3 jeweils einen Optokoppler 9 auf, welcher Optokoppler 9 invers zu den Optokopplern 4 in den Kontrollausgängen 2 geschaltet sind.

Der Kontrollausgang 2 mit der Bezeichnung CO2 ist über zwei Leitungen 10 und 11 mit den Eingängen 3 verbunden, welche die Bezeichnung E3 und E4 haben. Diese Eingänge 3 mit den Bezeichnungen E3 und E4 sind als komplementäre Eingänge ausgebildet, d. h., daß diese Eingänge mit einem geführten NO- und NC-Kontaktschalter verbunden sind. Diese Schaltelemente sind in der Fig. 1 mit dem Bezugszeichen 12 bezeichnet.

Schließlich ist der Kontrollausgang 2 mit der Bezeichnung CO1 über eine Leitung 13 an einen Funktionswahlschalter 14 angeschlossen, der drei aktive Ausgänge 15 und einen Ausgang 16 hat. Für den Funktionswahlschalter 14 kann die Leitung 13 wahlweise auf einen aktiven Ausgang 15 oder den Ausgang 16 geschaltet werden, wobei der Ausgang 16 mit dem Eingang 3 verbunden ist, welcher die Bezeichnung E5 hat. Die aktiven Ausgänge 15 sind mit den Eingängen 3 mit den Bezeichnungen E6 bis E8 verbunden. Bei den Eingängen 3 mit den Bezeichnungen E5 bis E8 handelt es sich um selektive Eingänge.

Den Eingängen 3 mit den Bezeichnungen E1 bis E8 kann jeweils das Signal μP2 entnommen werden.

Bei der in Fig. 1 dargestellten Sicherheitsschaltung 1 handelt es sich um eine solche, die zwei Einzeleingänge 3, zwei komplementäre Eingänge 3 und vier selektive Eingänge 3 aufweist, die mit vier Kontrollausgängen 2 geschaltet sind.

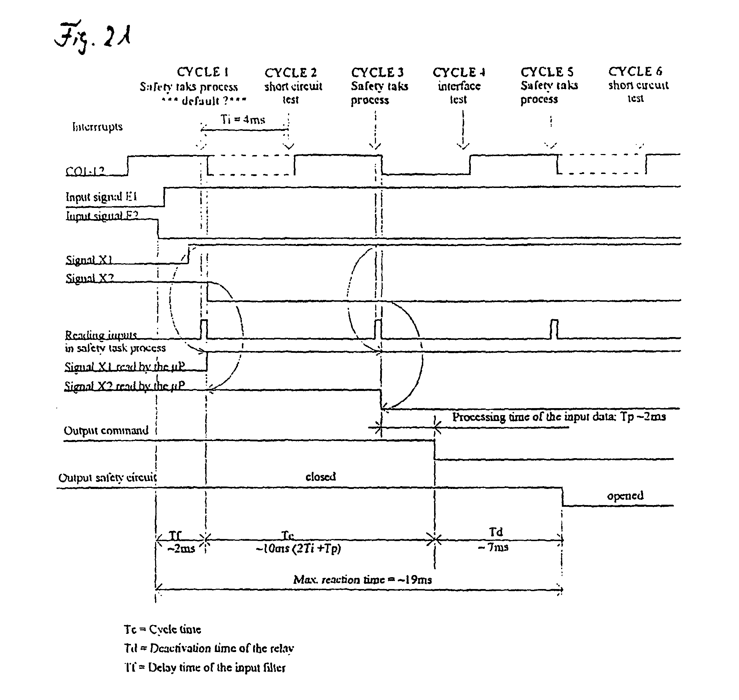

In Fig. 2 sind die möglichen Kurzschlüsse zwischen den Eingängen 3 mit den Bezeichnungen E1 bis E8 dargestellt. Hierbei ist die Anzahl der möglichen Kurzschlüsse eine Funktion der Anzahl der Eingänge 3. Aus der nachfolgenden Tabelle 1 ergibt sich eine Übersicht der Abhängigkeit zwischen der Anzahl der Eingänge 3 und der Anzahl der möglichen Kurzschlüsse.

Tabelle 1

| Number of inputs | Number of possible short circuits |
|---|---|
| 4 | 6 |
| 5 | 10 |

Tabelle 1   (fortgesetzt)

| Number of inputs | Number of possible short circuits |
|---|---|
| 6 | 15 |
| 7 | 21 |
| 8 | 28 |
| 9 | 36 |
| 10 | 45 |
| 11 | 55 |
| 12 | 66 |
| 13 | 78 |
| 14 | 91 |
| 15 | 105 |
| 16 | 120 |

Die Anzahl der möglichen Kurzschlüsse kann nach folgender Formel definiert werden:

$$N= (X-1) + (X-2) +.....+ 1,$$

wobei X die Anzahl der Eingänge 3 ist.

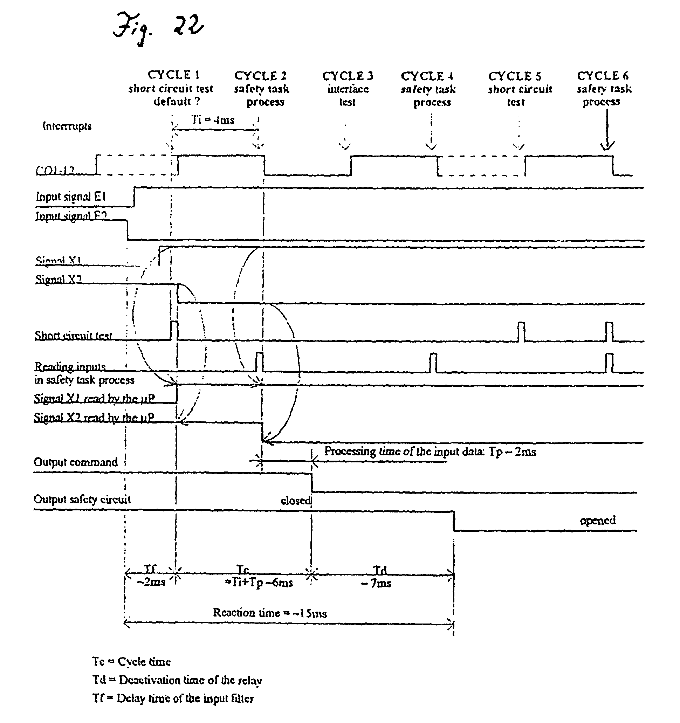

Zur Überprüfung der möglichen Kurzschlüsse zwischen den Eingängen 3 mit der Bezeichnung E1 und E2 ist ein sequentieller Test vorgesehen, bei dem die einzelnen Eingänge E1 und E2 generell an den Schaltelementen 6 oder an einer feedback-Schleife angeschlossen sind. Jeder Eingang 3 wird von einem einzelnen Kontrollausgang 2 versorgt. Eine erweiterte Sicherheitsschaltung 17 mit drei Eingängen 3, die die Bezeichnung E1 bis E3 tragen und drei Kontrollausgängen 2 ist in Fig. 3 dargestellt. Diese Sicherheitsschaltung 17 entspricht somit im Aufbau der Sicherheitsschaltung 1 gemäß Fig. 1 im Umfang der Eingänge 3 mit den Bezeichnungen E1 und E2 sowie den Kontrollausgängen 2 mit den Bezeichnungen CO3 und C04. Darüber hinaus ist ein zusätzlicher Kontrollausgang 2 und ein zusätzlicher Eingang 3 vorgesehen. Von daher sind in Fig. 3 mit Fig. 1 übereinstimmende Bezugszeichen verwendet, soweit gleiche Bauelemente Verwendung finden. Es versteht sich von selbst, daß die Sicherheitsschaltung 17 weitere Kontrollausgänge 2 und Eingänge 3 aufweisen kann, wobei die Anzahl der Kontrollausgänge 2 mit der Anzahl der Eingänge 3 übereinstimmt.

In Fig. 4 ist schematisch das Prinzip des sequentiellen Überprüfungstestes der Kontrollausgänge 2 während einer Testphase als Zeitablaufdiagramm dargestellt. Es ist zu erkennen, daß für jeden Kontrollausgang 2 mit der Bezeichnung CO1 bis COn eine bestimmte Phase vorgesehen ist. Während dieser Phasen, die in der Fig. 4 als Phase 1 bis Phase n bezeichnet sind, wird jeweils nur ein Kontrollausgang 2 aktiviert, d. h., daß in der Phase 1 der Kontrollausgang 2 mit der Bezeichnung CO1, in der Phase 2 der Kontrollausgang 2 mit der Bezeichnung CO2, in der Phase 3 der Kontrollausgang 2 und in der Phase n der Kontrollausgang 2 mit der Bezeichnung COn aktiviert ist. Am Ende einer jeden Phase werden alle Eingangssignale gleichzeitig gelesen. Sofern kein Kurzschluß vorliegt, ist in jeder Phase lediglich das durch den jeweiligen Kontrollausgang 2 abgegebene Eingangssignal und der damit verbundene Eingang aktiviert und auf ein Niveau 1 geschaltet.

Ein Kurschluß wird nur dann verifiziert, wenn mehr als ein Eingang 3 auf das Niveau 1 geschaltet ist, wie es beispielsweise durch den in Fig. 5 dargestellten Kurschluß erfolgt. Dieser Kurschluß besteht hinter den beiden Schaltern 6, die die Kennzeichnung S1 und S2 tragen.

Weiterhin wird dann ein Kurzschluß verifiziert, wenn ein Eingang 3 auf das Niveau 1 geschaltet ist, dieser Eingang 3 aber nicht mit dem aktivierten Kontrollausgang 2 korrespondiert. Dieser Kurzschluß ist in Fig. 6 dargestellt und besteht darin, daß eine Verbindung vor dem Schaltelement 6 mit der Bezeichnung S1 mit einer Leitung hinter dem Schaltelement 6 mit der Bezeichnung S2 besteht. In gleicher Weise wird ein derartiger Kurzschluß dann verifiziert, wenn die Leitungen vor den Schaltelementen 6 mit den Bezeichnungen S1 und S2 im Kurzschluß miteinander sind.

Bei einigen Kurzschlüssen kann die Erkennung nur dann erfolgen, wenn das korrespondierende Schaltelement 6 geschlossen ist. Eine derartige Konstellation ist beispielsweise in den Fig. 8 und 9 dargestellt. Diese Kurzschlüsse können dann nur erkannt werden, wenn entweder das Schaltelement 6 mit der Bezeichnung S1 oder das Schaltelement 6 mit der Bezeichnung S2 geschlossen ist. Dennoch besteht die Möglichkeit, daß einige derartige Kurzschlüsse erkannt werden, auch wenn die Schaltelemente 6 geöffnet sind, wenn der Status eines jeden Kontrollausgangs 2 gleichzeitig mit dem Eingangssignal µP der Eingänge 3 gelesen wird. Hierzu ist in Fig. 10 eine alternative Ausgestaltung dargestellt, die im wesentlichen mit der Fig. 8 übereinstimmt, jedoch hinsichtlich der Überwachung der Ausgangssignale der Kontrollausgänge 2 ergänzt ist. Hierzu sind in Fig. 10 zwei Leitungen 18 dargestellt, die jeweils an einen Kontrollausgang 2 mit der Bezeichnung CO1 oder CO2 angeschlossen sind und den jeweiligen Status der Kontrollausgänge 2 überwachen.

In der nachfolgenden Tabelle 2 ist beispielhaft die Auswertung der ersten beiden Überwachungsphasen dargestellt. Hierbei ist darauf hinzuweisen, daß das Lesen des Status der beiden Kontrollausgänge 2 mit den Bezeichnungen CO1 und CO2 gleichzeitig einen Selbsttest der Kontrollausgangsschnittstellen erlaubt.

Tabelle 2

| Control output Nr. | 1 | 2 | 3 | 4 | 5 | 6 | 7 | 8 | 9 | 10 | 11 | 12 | Interpretation |
|---|---|---|---|---|---|---|---|---|---|---|---|---|---|
| Control out. status | 0 | 0 | 0 | 0 | 0 | 0 | 0 | 0 | 0 | 0 | 0 | 0 | Control output CO1 is defective |
| | 1 | 0 | 0 | 0 | 0 | 0 | 0 | 0 | 0 | 0 | 0 | 0 | normal state |
| phase 1 (CO1=1) | 1 | 0 | 0 | 0 | 0 | 1 | 0 | 0 | 0 | 0 | 0 | 0 | short circuit between the control outputs CO1 and CO6 |
| Control out. status | 0 | 0 | 0 | 0 | 0 | 0 | 0 | 0 | 0 | 0 | 0 | 0 | Control output CO2 is defective |
| | 0 | 1 | 0 | 0 | 0 | 0 | 0 | 0 | 0 | 0 | 0 | 0 | normal state |
| phase 2 (CO2=1) | 0 | 1 | 0 | 0 | 0 | 0 | 0 | 0 | 1 | 0 | 0 | 0 | short circuit beween the control outputs CO2 and CO9 |

In der Tabelle 2 ist in Phase 1 der Kontrollausgang CO1 defekt, wenn der Status des Kontrollausgangs CO1 Null ist. Befindet sich der Status des Kontrollausgangs CO1 auf dem Niveau 1, so liegt ein fehlerfreier Status vor. Ein Kurzschluß zwischen zwei Kontrollausgängen CO1 und CO6 liegt dann vor, wenn sich in Phase 1 sowohl der Kontrollausgang CO1 als auch der Kontrollausgang CO6 auf dem Niveau 1 befinden. Gleiches ist für die Phase 2 tabellarisch dargestellt, wobei zum Beispiel ein Kurzschluß zwischen den Kontrollausgängen CO2 und CO9 angenommen ist.

In Fig. 11 ist ein Teil der Sicherheitsschaltung 1 gemäß Fig. 1 dargestellt, welcher Teil aus einem Kontrollausgang 2 und zwei Eingängen 3 besteht, wobei die Eingänge 3 mit den Bezeichnungen E1 und E2 als komplementäre Eingänge ausgebildet sind, die an ein Schaltelement 12 angeschlossen sind. Die komplementären Eingänge 3 mit der Bezeichnung E1 und E2 sind über den gemeinsamen Schalter 12 an einen einzelnen Kontrollausgang 2 mit der Bezeichnung CO1 angeschlossen. Ein Kurzschluß zwischen den Eingängen 3 mit der Bezeichnung E1 und E2 oder zwischen einem Eingang 3 (E1 oder E2) und einem anderen Eingang 3 kann dann durch den zuvor beschriebenen sequentiellen Test erkannt werden, wenn zwei Eingänge 3 zu einer bestimmten Zeit das Niveau 1 haben, unabhängig von der Art der Eingänge 3. Die zuvor beschriebene Vorgehensweise kann daher auch auf diesen Teil der Sicherheitsschaltung 1 angewendet werden.

In Analogie zu Fig. 11 ist in Fig. 12 ein Teil der Sicherheitsschaltung 1 dargestellt, welcher Teil aus einem Kontrollausgang 2 und vier Eingängen 3 besteht, wobei der Kontrollausgang 2 über die Leitung 13 mit einem Funktionswahlschalter 14 verbunden ist, an dessen drei aktiven Ausgängen 15 und dem Ausgang 16 die vier Eingänge 3 mit den Bezeichnungen E1 bis E4 angeschlossen sind. Die Eingänge 3 sind demzufolge als selektive Eingänge 3 ausgebildet.

Auch in diesem Fall können die voranstehenden Ausführungen bezüglich der Überwachung der Kurzschlüsse herangezogen werden. Ein Kurzschluß zwischen zwei selektiven Eingängen 3 oder zwischen einem selektiven Eingang 3 und einem weiteren Eingang 3 kann durch den voranstehend beschriebenen Test erkannt werden, da lediglich ein Eingang 3 zu einer bestimmten Zeit das Niveau 1 haben kann.

Der voranstehend beschriebene sequentielle Überprüfungstest für zwölf Kontrollausgänge 2 hat zumindest elf Phasen, in denen die einzelnen Signale gelesen werden. Vorzugsweise erfolgt das Lesen der Signale jedoch in zwölf Phasen, wobei jedoch die Signale in der zwölften Phase redundant sind mit den Signalen der elf anderen Phasen. Dennoch hat es sich als vorteilhaft erwiesen, zwölf Phasen zur Überprüfung eventueller Kurzschlüsse und / oder Fehler vorzusehen, um gleichzeitig einen Test aller Kontrollausgänge 2 durchzuführen. Jede Phase benötigt 3 bis 5, vorzugsweise 4 ms Zeit. Hieraus ergibt sich eine Gesamttestzeit von maximal 48 ms. Diese gesamte Testphase nimmt somit mehr als die doppelte Zeit der maximal möglichen Reaktionszeit von 20 ms in Anspruch, so daß die Anwendung des voranstehend beschriebenen Verfahrens zur Überprüfung der Sicherheitsschaltung 1 nur mit einem unzulänglichen Ergebnis durchführbar ist.

Erfindungsgemäß ist nun vorgesehen, daß das Verfahren zur Überprüfung einer Sicherheitsschaltung 1 auf eventuelle Kurzschlüsse und / oder Fehler phasenweise durchgeführt wird, wobei in jeder Phase mehr als ein Kontrollausgang 2 aktiviert wird. Gemäß der nachfolgenden Tabelle 3 kann die Anzahl der Testphasen für fünf Kontrollausgänge 2 auf drei reduziert werden.

Tabelle 3

|  | CO1 | CO2 | CO3 | CO4 | CO5 | Short circuits that can be detected | | | | | |
| --- | --- | --- | --- | --- | --- | --- | --- | --- | --- | --- | --- |
| Phase 1 | 1 | 0 | 1 | 0 | 1 | 1-2 | 1-4 | 3-2 | 3-4 | 5-2 | 5-4 |
| Phase 2 | 1 | 0 | 1 | 1 | 0 | 1-2 | 1-5 | 3-2 | 3-5 | 4-2 | 4-5 |
| Phase 3 | 1 | 0 | 0 | 0 | 0 | 1-2 | 1-3 | 1-4 | 1-5 | | |

Nach dieser Vorgehensweise können in der ersten Phase sechs mögliche Kurzschlüsse erkannt werden. Hierbei handelt es sich um Kurzschlüsse zwischen den Eingängen 3 mit den Bezeichnungen E1 - E2, E1 - F4, E3 - E2, E3 - E4, E5 - E2 und E5 - E4. In der darauffolgenden zweiten Phase können weitere drei mögliche Kurzschlüsse erfaßt werden, nämlich Kurzschlüsse zwischen den Eingängen 3 mit den Bezeichnungen E1 - E5, E3 - E5 und E4 - E2. Schließlich wird in der dritten Phase noch der verbleibende mögliche Kurzschluß zwischen den Kontrollausgängen 2 mit den Bezeichnungen E1 - E3 erfaßbar.

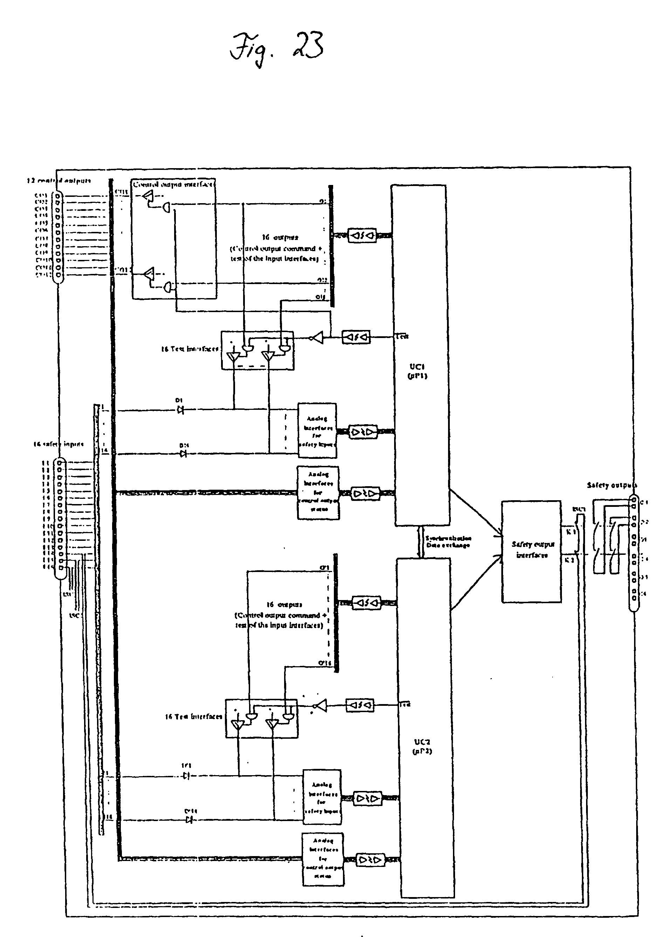

In den Fig. 13 und 14 sind die möglichen Kurzschlußkonstellationen nochmals grafisch dargestellt. Die in der ersten Phase nicht erkannten Kurzschlüsse entsprechen den Kurzschlüssen zwischen den Kontrollausgängen 2 mit einem Niveau 1 oder zwischen den Kontrollausgängen mit einem Niveau 0 in der ersten Phase. Demzufolge ist es in der Phase 2 lediglich notwendig, eine entsprechende Konfiguration anzuwenden, welche die verbleibenden möglichen Fehler erkennt. In gleicher Weise wird die dritte Phase durchgeführt, in welcher bei dem vorliegenden Beispiel lediglich noch ein Kurzschluß zwischen den Eingängen 3 mit der Bezeichnung E1 und E3 erkennbar macht.

Alle Kurzschlüsse können dann entdeckt werden, wenn die Kontrollausgänge 2 mit einem unterschiedlichen Binär-Code versehen sind. Eine einfache Möglichkeit, die Kurzschlüsse nach dem erfinderischen Verfahren zu analysieren, besteht somit darin, jedem Kontrollausgang 2 einen unterschiedlichen Binär-Code zuzuordnen, beispielsweise "01" für den Kontrollausgang 2 mit der Bezeichnung CO1 aufsteigend bis zum Binär-Code "n" für den Kontrollausgang 2 mit der Bezeichnung COn, wobei n die Anzahl der Kontrollausgänge 2 repräsentiert.

Eine alternative Konfiguration ergibt sich aus der nachfolgenden Tabelle 4, die alternativ zur Tabelle 3 anzuwenden ist.

Tabelle 4

|  | CO1 | CO2 | CO3 | CO4 | CO5 | Short circuits that can be detected | | | | | |
| --- | --- | --- | --- | --- | --- | --- | --- | --- | --- | --- | --- |
| Phase 1 | 1 | 0 | 1 | 0 | 1 | 1-2 | 1-4 | 3-2 | 3-4 | 5-2 | 5-4 |
| Phase 2 | 0 | 1 | 1 | 0 | 0 | 2-7 | 2-4 | 2-5 | 3-1 | 3-4 | 3-5 |
| Phase 3 | 0 | 0 | 0 | 1 | 1 | 4-1 | 4-2 | 4-3 | 5-1 | 5-2 | 5-3 |

Die Anzahl der notwendigen Phasen ist abhängig von der Anzahl der Eingänge 3 und demzufolge auch von der Anzahl der Kontrollausgänge 2. Für $N_{CO}$-Kontrollausgänge 2 müssen demzufolge zumindest $N_{CO}$ verschiedene Binär-Codes bereitgestellt werden. Demzufolge muß N so gewählt werden, daß $2^N < N_{CO}$, so daß sich für die Anzahl der Testphasen N folgende Formel ergibt:

$$N \geq \frac{LogN_{CO}}{Log2}$$

wenn ein Test der Kontrollausgänge nicht erfolgt.

Nach dieser Formel ergibt sich für verschiedene Anzahlen von Kontrollausgängen 2 folgende Relation gemäß Tabelle 5:

Tabelle 5

| Number of control outputs Nco | 4 | 8 | 12 | 16 |
|---|---|---|---|---|
| Max. number of possible short circuits | 6 | 28 | 66 | 120 |
| Number of test phases N | 2 | 3 | 4 | 4 |
| Number of test phases N allowing an additional and simultaneous test of all the control outputs | 3 | 4 | 4 | 5 |

Damit die Kontrollausgänge geprüft werden können, dürfen sie nicht mit dem gleichen Wort während der verschiedenen Phasen gesteuert werden. Das heißt, die zwei Codes mit allen Bit = g"o" und allen Bit = "1" sind auszuschliessen.

Sollen die Kontrollausgänge geprüft werden, so ergibt sich folgende Formel:

$$N \geq \frac{\text{Log} \, (N_{CO} + 2)}{\text{Log} \, 2}$$

$N_{CO}$ ist hierbei die Anzahl der Kontrollausgänge.

Ein zu dem eingangs nach dem Stand der Technik beschriebenen Verfahren anwendbares Verfahren nach der Erfindung hat lediglich vier Phasen im Vergleich zu den zwölf Phasen nach dem Stand der Technik. Jede Phase benötigt hierbei 4 ms, so daß sich eine Gesamtzeit zur Überprüfung der Sicherheitsschaltung von 16 ms ergibt. Somit wird nur noch ein Drittel der Zeit nach dem Stand der Technik zur Überprüfung einer Sicherheitsschaltung auf eventuelle Kurzschlüsse und / oder Fehler benötigt.

Nachfolgend wird das erfindungsgemäße Verfahren als vollständiger Test zur Überprüfung eventueller Kurzschlüsse und zur Überprüfung der Eingangsschnittstellen dargestellt und beschrieben.

In Fig. 15 ist der Zeitablauf des Verfahrens zur Überprüfung eventueller Kurzschlüsse und / oder Fehler bei zwölf Kontrollausgängen 2 mit den Bezeichnungen CO1 bis CO12 sowie der Eingangsschnittstellen dargestellt. Hierbei werden in sechs Abschnitten (Phasen) alternierend die Eingangsdaten gelesen und ein Kurzschlußtest durchgeführt. Die Unterbrechungszeit zwischen jeweils zwei benachbarten Abschnitten beträgt 4 ms, wobei die Eingangsdaten alle 8 ms gelesen werden. Der Kurzschlußtest und die Überprüfung der Eingangsschnittstellen erfolgt alle 16 ms.

Wie sich aus Fig. 15 ergibt, nimmt der gesamte Überprüfungstest 16 ms in Anspruch. Für zwölf Kontrollausgänge 2 sind bei einem nach dem Stand der Technik arbeitenden sequentiellen Test zwölf Abschnitte (Phasen) notwendig, so daß die Dauer eines gesamten Kurzschlußtestes 192 ms in Anspruch nimmt.

In Fig. 16 ist die notwendige Zeit für einen sequentiellen Kurzschlußtest in Abhängigkeit der Kontrollausgänge 2 dargestellt.

Bei einem erfindungsgemäßen Verfahren sind unter gleichen Bedingungen, d. h. bei einer Überprüfung von zwölf Kontrollausgängen 2 lediglich vier Abschnitte notwendig, so daß sich eine Gesamtzeitdauer von 64 ms für die gesamte Durchführung der Kurzschlußüberprüfung ergibt. Alternativ zu Fig. 16 ist in Fig. 17 die Zeitdauer der Kurzschlußüberprüfung in Abhängigkeit der Anzahl der Kontrollausgänge nach dem erfindungsgemäßen Verfahren dargestellt. Hierbei ist zu erkennen, daß durch das erfindungsgemäße Verfahren eine wesentliche Verkürzung der Zeitdauer für die Kurzschlußüberprüfung erzielbar ist.

In einigen bestimmten Fällen kann die Kurzschlußüberprüfung zu einer falschen Diagnose führen. Diese Fälle treten jedoch nur dann auf, wenn entweder komplementäre oder selektive Eingänge 3 überprüft werden, da hier durch Veränderungen der Schalterstellungen Zeitspannen entstehen können, die fälschlicherweise mit einem Kurzschluß oder mit einem anderen Fehler verwechselt werden. In der Fig. 18 ist eine solche Situation bei der Verwendung von komplementären Eingängen 3 dargestellt, wobei im oberen Teil der Fig. 18 nochmals ein vereinfachtes Schaltbild und im unteren Teil der Fig. 18 ein Zeitablaufdiagramm dargestellt ist. Insoweit stimmt der obere Teil der Fig. 18 im wesentlichen mit der Fig. 11 überein.

Für den Fall, daß das Schaltelement 12 mit der Bezeichnung SW1 aktiviert wird, d. h. in Richtung des Pfeiles 19 geschaltet wird, ändert sich der Status der Eingänge 3 mit den Bezeichnungen E1 und E2. Die Zeitverschiebung zwischen jedem Eingangsfilter kann jedoch für jeden Eingang 3 nicht identisch sein. Daher ergibt sich ein gewisser Zeitsprung zwischen X1 und X2 gemäß dem unteren Teil der Fig. 18, in dem der Zustand der Eingänge 3 mit der Bezeichnung E1 und E2 gelesen wird. Hierbei kann in beiden Fällen das Niveau 1 anliegen, so daß die Sicherheitsschaltung einen Kurzschluß erkennt, obwohl ein Fehler nicht vorliegt.

In gleicher Weise kann ein derartiger Fehler in Fig. 19 auftreten, welche entsprechend der Fig. 12 eine Sicherheitsschaltung 1 mit einem Kontrollausgang 2 und 4 als selektive Eingänge ausgebildete Eingänge 3 zeigt.

Um derartige Fehler auszuschließen oder zu überprüfen, ist ein Ablauf gemäß den Fig. 20 bis 22 vorgesehen. Hierbei zeigt Fig. 20 den Zeitablauf bei Durchführung des erfindungsgemäßen Verfahrens. Das Zeitablaufdiagramm ist für die voranstehend beschriebene Sicherheitsschaltung mit zwölf Kontrollausgängen 2 dargestellt, die die Bezeichnung CO1 bis CO12 tragen. Im wesentlichen lehnt sich das Zeitablaufdiagramm in den Fig. 20 bis 22 an das Zeitablaufdiagramm gemäß Fig. 15 an, d. h., daß entsprechende Parameter vorgesehen sind.

Das Verfahren zur Überprüfung einer Sicherheitsschaltung mit zwölf Kontrollausgängen 2 auf eventuelle Kurzschlüsse und / oder Fehler ist in 6 Abschnitte unterteilt, wobei die Abschnitte 1, 3 und 5 dem Lesen der übermittelten Signale dienen, die Abschnitte 2 und 6 als Kurzschlußtests und der Abschnitt 4 als Test zur Überprüfung der Schnittstellen ausgebildet ist. In Analogie zu Fig. 15 beträgt die Unterbrechungszeit Ti 4 ms.

Gemäß Fig. 20 ist eine Verspätungszeit für den Eingangsfilter 20 von 2 ms vorgesehen, an den sich eine Abschnittszeit von 10 ms und anschließend eine Deaktivierungszeit des Relais von 7 ms anschließt. Hierbei ist die Deaktivierungszeit des Relais mit der Bezeichnung Td und die Abschnittszeit mit der Bezeichnung Tc angegeben. Die Abschnittszeit errechnet sich aus der doppelten Unterbrechungszeit zuzüglich 2 ms. Aus der Fig. 20 ergibt sich somit eine maximale Reaktionszeit von ungefähr 19 ms.

Während der Lesephase der Eingangssignale oder während der Kurzschlußtestphase kann es zu Situationen kommen, die ein falsches Ergebnis hinsichtlich des Vorliegens eines Fehlers und / oder eines Kurzschlusses signalisiert.

In Fig. 21 ist eine Situation dargestellt, bei welcher ein eventueller Fehler und/oder Kurzschluß während einer Überprüfungsphase erkannt wird. Es muß in möglichst kurzer Zeit entschieden werden, ob ein wahrer Fehler vorliegt oder nicht. Hierbei ist es notwendig, daß der Fehler durch eine zweite Lesephase bestätigt wird, bevor die Sicherheitsschaltung den elektrischen Verbraucher abschaltet bzw. ein Einschalten verhindert.

In dieser zweiten Lesephase werden nur die Sicherheitsausgänge aktualisiert, die nicht zu den vom eventuellen Kurzschluß betroffenen Sicherheitsfunktionen gehören.

In der nächsten Überprüfungsphase wird das zweite Lesen der Eingangssignale durchgeführt. Wird in diesem Abschnitt der Fehler bestätigt, schaltet die Sicherheitsschaltung den elektrischen Verbraucher ab. In jedem anderen Fall werden sämtliche Sicherheitsausgänge wieder aktualisiert. Es ergibt sich auch im Fehlerfall eine Reaktionszeit von weniger als 19ms, bis der Ausgangssicherheitsschaltkreis geöffnet wird.

In Fig. 22 ist eine Situation dargestellt, bei welcher ein eventueller Fehler und /oder Kurzschluß während eines Kurzschlußtestes erkannt wird. Hierbei ist es notwendig, daß der Fehler durch eine zweite Lesephase bestätigt wird, bevor die Sicherheitsschaltung den elektrischen Verbraucher abschaltet bzw. ein Einschalten verhindert. Im nächsten Abschnitt, d. h. im Leseabschnitt der Eingangssignale wird dieses zweite Lesen der Eingangssignale durchgeführt. Anschließend wird der elektrische Verbraucher abgeschaltet, wenn der zuvor festgestellte Fehler bestätigt wird.

Liegt kein Fehler vor, werden sämtliche Ausgangssignale der Sicherheitsausgänge aktualisiert. Gemäß Fig. 22 ist zu erkennen, daß auch in diesem Fall die maximale Reaktionszeit ungefähr 19 ms beträgt und somit geringer als die maximal erlaubte Reaktionszeit von 20 ms ist.

Hieraus folgt, daß ein irrtümlich erkannter Fehler in einfacher Weise überprüft werden kann, ohne daß die Reaktionszeit wesentlich verlängert wird.

Schließlich ist in Fig. 23 die Anwendung des erfindungsgemäßen Verfahrens zur Überprüfung von Eingangsschnittstellen dargestellt. Hierzu zeigt Fig. 23 einen Prinzipsschaltplan einer entsprechenden Sicherheitsschaltung, die mehrere Schnittstellen aufweist.

Um Eingangsschnittstellen zu überprüfen, ist ein zusätzlicher Befehl notwendig. Dieser als "Test" bezeichnete Befehl ist aktiviert, wenn ein Niveau O anliegt. Sollen die Eingangsschnittstellen durch den Mikroprozessor überprüft werden, setzt der Mikroprozessor den Befehl zurück, so daß sämtliche Kontrollausgänge deaktiviert werden, d. h. ein Niveau O annehmen und die elektronischen Schalter des Mikroprozessors gleichzeitig freigegeben werden. Der Mikroprozessor kann dann die Ausgänge, die hier mit O1 bis 016 angegeben sind, mit den Testbedingungen ansteuern. Diese Testbedingungen werden dann direkt den Schnittstelleneingängen über die elektronischen Schalter übertragen. Diese Testbedingungen entsprechen exakt den Bedingungen beim Kurzschlußtest, jedoch müssen bei der Überprüfung der Schnittstellen sechzehn Kontrollausgänge angesteuert werden, so daß fünf Testphasen notwendig sind. Es folgt hieraus dieselbe Fehleranalyse, wie sie zuvor für die Sicherheitsschaltung 1 gemäß Fig. 1 dargestellt wurde. In der nachfolgenden Tabelle 6 sind entsprechende Kontrollausgangswerte dargestellt.

Tabelle 6

| Control output Nr. | 1 | 2 | 3 | 4 | 5 | 6 | 7 | 8 | 9 | 10 | 11 | 12 | 13 | 14 | 15 | 16 |
|---|---|---|---|---|---|---|---|---|---|---|---|---|---|---|---|---|
| standby | 0 | 0 | 0 | 0 | 0 | 0 | 0 | 0 | 0 | 0 | 0 | 0 | 0 | 0 | 0 | 0 |
| reading inputs | 1 | 1 | 1 | 1 | 1 | 1 | 1 | 1 | 1 | 1 | 1 | 1 | 0 | 0 | 0 | 0 |
| Short circuit test -Phase 1 | 1 | 0 | 1 | 0 | 1 | 0 | 1 | 0 | 1 | 0 | 1 | 0 | 0 | 0 | 0 | 0 |
| Short circuits test -Phase 2 | 0 | 1 | 1 | 0 | 0 | 1 | 1 | 0 | 0 | 1 | 1 | 0 | 0 | 0 | 0 | 0 |
| Short circuits test -Phase 3 | 0 | 0 | 0 | 1 | 1 | 1 | 1 | 0 | 0 | 0 | 0 | 1 | 0 | 0 | 0 | 0 |
| Short circuits test -Phase 4 | 0 | 0 | 0 | 0 | 0 | 0 | 0 | 1 | 1 | 1 | 1 | 1 | 0 | 0 | 0 | 0 |
| Interface test -Phase 1 | 1 | 0 | 1 | 0 | 1 | 0 | 1 | 0 | 1 | 0 | 1 | 0 | 1 | 0 | 1 | 0 |
| Inferface test -Phase 2 | 0 | 1 | 1 | 0 | 0 | 1 | 1 | 0 | 0 | 1 | 1 | 0 | 0 | 1 | 1 | 0 |
| Interface test -Phase 3 | 0 | 0 | 0 | 1 | 1 | 1 | 1 | 0 | 0 | 0 | 0 | 1 | 1 | 1 | 1 | 0 |
| Interface test -Phase 4 | 0 | 0 | 0 | 0 | 0 | 0 | 0 | 1 | 1 | 1 | 1 | 1 | 1 | 1 | 1 | 0 |
| Interface test -Phase 5 | 0 | 0 | 0 | 0 | 0 | 0 | 0 | 0 | 0 | 0 | 0 | 0 | 0 | 0 | 0 | 1 |

Das voranstehend beschriebene Verfahren hat insbesondere den Vorteil, daß die Testzeit gegenüber dem Stand der Technik wesentlich verkürzt wird, insbesondere dann, wenn eine sehr große Anzahl von Eingängen zu überprüfen ist. Die Testzeit wächst nicht als lineare Funktion der Anzahl der Kontrollausgänge. Darüber hinaus kann die Verdrahtung der Sicherheitsschaltung mit einer höheren Sicherheitsrate überprüft werden. Ferner werden mögliche Kurzschlüsse in verschiedenen Phasen überwacht und überprüft, so daß durch entsprechende Redundanz eine größere Sicherheit erzielt wird. Das erfindungsgemäße Verfahren ist schließlich auch zur Überprüfung von Eingangsschnittstellen mit den gleichen Vorteilen anwendbar.

**Patentansprüche**

**1.**  Verfahren zur Überprüfung einer Sicherheitsschaltung für elektrische Maschinen, insbesondere Pressen oder dergleichen auf eventuelle Kurzschlüsse und/oder Fehler, mit zumindest einem Kontrollausgang und zumindest einem Eingang, wobei die Anzahl der Eingänge von der Anzahl der Kontrollausgänge abweicht, und jeder Kontrollausgang ein Ausgangssignal abgibt, welche Ausgangssignale den Eingängen als Eingangssignale zugeleitet werden, und jedes Ausgangssignal zur Überprüfung eines möglichen Kurzschlusses genutzt wird,

**dadurch gekennzeichnet,**

**daß** mehrere, zumindest zwei Ausgangssignale parallel, d. h. im wesentlichen gleichzeitig während einer Phase hinsichtlich der Prüfung eines möglichen Kurzschlusses zwischen zwei Eingängen genutzt werden und daß die Gesamtzahl der Ausgangssignale in mehreren, nacheinander ablaufenden Phasen geprüft werden, wobei jede Phase der Prüfung mehrerer, zumindest zweier Ausgangssignale und / oder Eingangssignale dient.

2. Verfahren nach Anspruch 1,
   **dadurch gekennzeichnet,**
   **daß** jedem Ausgangssignal ein Binärcode zugewiesen wird.

3. Verfahren nach Anspruch 1,
   **dadurch gekennzeichnet,**
   **daß** die Anzahl der Phasen (N) in Abhängigkeit der
   Ausgangs- bzw. Eingangssignale ($N_{CO}$) nach der Formel

$$N \geq \frac{\text{Log}N_{CO}}{\text{Log}2}$$

ohne Test der Kontrollausgänge bzw. nach der Formel

$$N \geq \frac{\text{Log}(N_{CO} + 2)}{\text{Log}}$$

mit Test der Kontrollausgänge gesteuert wird.

4. Verfahren nach Anspruch 1,
   **dadurch gekennzeichnet,**
   **daß** die Sicherheitsschaltung zur Abschaltung eines Verbrauchers aktiviert wird, wenn während zumindest einer Phase zumindest ein Kurzschluß erkannt wird.

5. Verfahren nach Anspruch 1,
   **dadurch gekennzeichnet,**
   **daß** bei Erkennen eines Kurzschlusses die Überprüfung eventueller Kurzschlüsse in der Sicherheitsschaltung vollständig neu durchgeführt wird.

6. Verfahren nach Anspruch 5,
   **dadurch gekennzeichnet,**
   **daß** nach jeder Phase der erneuten Überprüfung eventueller Kurzschlüsse in der Sicherheitsschaltung die Kontrollausgangssignale eliminiert werden, die keinen Kurzschluß anzeigen.

7. Verfahren nach Anspruch 1,
   **dadurch gekennzeichnet,**
   **daß** die Überprüfung eventueller Kurzschlüsse und / oder Fehler in mehrere, zumindest zwei Abschnitte geteilt ist, wobei der zweite Abschnitt mehrere Phasen zur Prüfung der Kurzschlüsse aufweist und im ersten Abschnitt die Kontrollausgangssignale bzw. Eingangssignale gelesen und geprüft werden.

8. Verfahren nach einem der Ansprüche 1 bis 7,
   **dadurch gekennzeichnet,**
   **daß** ein ermittelter Kurzschluß und / Fehler in der Sicherheitsschaltung vor Aktivierung eines Abschaltmodus für den angeschlossenen Verbraucher bestätigt wird, wobei anschließend die Kontrollausgangssignale erneut abgegeben werden, die fehlerfrei sind.

**9.** Verfahren nach einem der Ansprüche 7 oder 8,
**dadurch gekennzeichnet,**
**daß** bei Erkennen eines fehlerhaften Ausgangs- und / oder Eingangssignals der nachfolgende Abschnitt zum erneuten Lesen und Prüfen der Kontrollausgangs- und / oder Eingangssignale genutzt wird.

**10.** Verfahren nach Anspruch 7,
**dadurch gekennzeichnet,**
**daß** bei Erkennen eines Kurzschlusses und/oder Fehlers im zweiten Abschnitt ein erneuter erster Abschnitt geschaltet wird, in welchem die Kontrollausgangs- bzw. Eingangssignale gelesen und geprüft werden.

**11.** Verfahren nach Anspruch 1,
**dadurch gekennzeichnet,**
**daß** parallel zur Überprüfung der Kontrollausgangs- bzw. Eingangssignale hinsichtlich eventueller Kurzschlüsse und / oder Fehler auch eine Überprüfung der Eingangsschnittstellen durchgeführt wird.

**12.** Verfahren nach Anspruch 11,
**dadurch gekennzeichnet,**
**daß** die Überprüfung der Eingangsschnittstellen phasenweise entsprechend der Überprüfung der Eingangs- bzw. Kontrollausgangssignale in den einzelnen Phasen abläuft.


**Claims**

**1.** Method for checking a safety circuit for electrical machines, in particular presses or the like, for possible short circuits and/or errors, with at least one control output and at least one input, wherein the number of inputs differs from the number of control outputs, and each control output emits an output signal, these output signals being passed on to the inputs as input signals, and each output signal is used for checking a possible short circuit,
**characterized in that**
several, at least two output signals are used in parallel, i.e. essentially simultaneously during a phase with regard to checking a possible short circuit between two inputs, and the total number of output signals is checked in several, successive phases, where each phase serves to test of several, at least two output signals and / or input signals.

**2.** Method as set forth in claim 1,
**characterized in that**
a binary code is assigned to each output signal.

**3.** Method as set forth in claim 1,
**characterized in that**
the number of phases (N) is controlled depending on the output and/or input signals ($N_{CO}$) according to the formula

$$N \geq \frac{\text{Log } N_{CO}}{\text{Log2}}$$

without testing of the control outputs, or according to the formula

$$N \geq \frac{\text{Log } (N_{CO}+2)}{\text{Log}}.$$

with testing of the control outputs.

**4.** Method as set forth in claim 1,
**characterized in that**
the safety circuit for switching-off a consumer is activated when during at least one phase at least one short circuit is detected.

**5.** Method as set forth in claim 1,

*characterized in that*
on detection of a short circuit, checking of possible short circuits in the safety circuit is executed completely again.

6. Method as set forth in claim 5,
   *characterized in that*
   after each phase of the renewed checking of possible short circuits in the safety circuit those control output signals are eliminated, which show no short circuit.

7. Method as set forth in claim 1,
   *characterized in that*
   the checking of possible short circuits and / or errors is divided into several, at least two sections, where the second section has several phases for checking the short circuits and in the first section the control output signals and/or input signals are read and checked.

8. Method as set forth in one of the claims 1 to 7,
   *characterized in that*
   a detected short circuit and / or error in the safety circuit is confirmed before activating a switch-off mode for the connected consumer, wherein subsequently the control output signals, which are error-free, are released again.

9. Method as set forth in one of the claims 7 or 8,
   *characterized in that*
   on detection of a defective output and / or input signal, the subsequent section is used for renewed reading and checking of the control output and / or input signals.

10. Method as set forth in claim 7,
    *characterized in that*
    on detection of a short circuit and / or error in the second section, a renewed first section is started, in which the control output and/or input signals are read and checked.

11. Method as set forth in claim 1,
    *characterized in that*
    in parallel to the checking of the control output and/or input signals with regard to possible short circuits and / or errors, also a checking of the input interfaces is performed.

12. Method as set forth in claim 11,
    *characterized in that*
    the checking of the input interfaces runs in phases according to the checking of the input and/or control output signals in the individual phases.

**Revendications**

1. Procédé pour tester un circuit de sécurité pour machines électriques, notamment les presses ou machines similaires, pour y détecter d'éventuels courts-circuits et/ou défaillances, comprenant au moins une sortie de contrôle et au moins une entrée, le nombre d'entrées étant différent du nombre de sorties de contrôle, et chaque sortie de contrôle délivrant un signal de sortie, ces signaux de sortie étant acheminés aux entrées en tant que signaux d'entrée, et chaque signal de sortie étant utilisé pour tester la présence d'un éventuel court-circuit,
   **caractérisé en ce que,**
   plusieurs, au moins deux, signaux de sortie sont utilisés en parallèle, c'est-à-dire simultanément au cours d'une phase du contrôle d'un éventuel court-circuit entre deux entrées, et le nombre total de signaux de sortie est contrôlé en plusieurs phases consécutives, chaque phase du contrôle utilisant plusieurs, au moins deux, signaux de sortie et/ou signaux d'entrée.

2. Procédé selon la Revendication 1,
   **caractérisé en ce que**,
   un code binaire est attribué à chaque signal de sortie.

3. Procédé selon la Revendication 1, **caractérisé en ce que**, le nombre des phases (N) est commandé en fonction des signaux de sortie et d'entrée ($N_{CO}$) selon la formule

$$N \geq \frac{\text{Log } N_{CO}}{\text{Log2}}$$

sans l'essai des sorties de contrôle par la formule

$$N \geq \frac{\text{Log } (N_{CO+2})}{\text{Log2}}$$

avec l'essai des sorties de contrôle.

4. Procédé selon la Revendication 1,
   **caractérisé en ce que**,
   le circuit de sécurité pour la mise hors tension d'un appareillage est activé lorsque au cours d'au moins une phase au moins un court-circuit est détecté.

5. Procédé selon la Revendication 1,
   **caractérisé en ce que**,
   lors de la détection d'un court-circuit le contrôle d'éventuels courts-circuits dans le circuit de sécurité est de nouveau réalisé en totalité.

6. Procédé selon la Revendication 5,
   **caractérisé en ce que**,
   après chaque phase du contrôle répété des éventuels courts-circuits dans le circuit de sécurité, les signaux de sortie de contrôle ne présentant pas de court-circuit sont éliminés.

7. Procédé selon la Revendication 1,
   **caractérisé en ce que**,
   le contrôle des éventuels courts-circuits et/ou défaillances est réparti en plusieurs, au moins deux, parties, la deuxième partie présentant plusieurs phases pour le contrôle des courts-circuits, et dans la première partie les signaux d'entrée ou de sortie de contrôle sont lus et contrôlés.

8. Procédé selon l'une des Revendications 1 à 7,
   **caractérisé en ce que**,
   le court-circuit et/ou la défaillance établi(e) dans le circuit de sécurité avant l'activation du mode de déconnexion pour l'appareillage raccordé est confirmé(e), à la fin les signaux de sortie de contrôle, exempts d'erreur étant délivrés de nouveau.

9. Procédé selon l'une des Revendications 7 ou 8,
   **caractérisé en ce que**,
   lors de la détection d'un signal de sortie et/ou d'entrée défaillant de la partie suivante est utilisé pour une nouvelle lecture et un nouveau contrôle des signaux de sortie et/ou d'entrée de contrôle.

10. Procédé selon la Revendication 7,
    **caractérisé en ce que**,
    lors de la détection d'un court-circuit et/ou d'une défaillance dans la deuxième partie, une nouvelle première partie est réalisée, au cours de laquelle les signaux d'entrée et de sortie de contrôle sont lus et contrôlés.

11. Procédé selon la Revendication 1,
    **caractérisé en ce que**,
    parallèlement au contrôle des signaux d'entrée et de sortie de contrôle pour détecter d'éventuels courts-circuits et/ou défaillances un contrôle des interfaces d'entrée est également réalisé.

12. Procédé selon la Revendication 11,
    **caractérisé en ce que**,

le contrôle des interfaces d'entrée se déroule par phase conformément au contrôle des signaux d'entrée et de sortie de contrôle en phases isolées.

## Fig. 1

*Fig. 2*

Fig. 3

## Fig. 4

Test phase

| | |
|---|---|
| CO1 | Phase 1 |
| CO2 | Phase 2 |
| CO3 | Phase 3 |
| COn | Phase n |

Input's reading
E1 --> En

## Fig. 5

17

CO2

CO1

E1

E2

S1

S2

G

2

2

3

*Fig. 6*

*Fig. 7*

Fig. 8

Fig. 9

# Fig. 10

Fig. 11

*Fig. 12*

*Fig.* 13

```
CO1     CO2     CO3     CO4     CO5
1       0       1       0       1
i__1_2__i
i_____1_4_____i
        i__3_2__i
                i__3_4__i
        i_____5_2_____i
                        i__5_4__i
```

*Fig.* 14

```
CO1     CO2     CO3     CO4     CO5
 1       0       1       1       0
 i_____1_5_____i
                i_____3_5_____i
        i_____2_4_____i
```

*Fig. 15*

|  | CYCLE 1<br>Safety tasks<br>process | CYCLE 2<br>short circuit<br>test | CYCLE 3<br>Safety tasks<br>process | CYCLE 4<br>interface<br>test | CYCLE 5<br>Safety tasks<br>process | CYCLE 6<br>short circuit<br>test |
|---|---|---|---|---|---|---|

Ti = 4ms

COI-12

Reading inputs

Safety task process

Short circuit test

Input interface test

*Fig. 16*

Time of test by using the sequential test (ms)

1024

896

768

640

512

384

256

128

0    8    16    24    32    40    48    56    64

Number of control outputs Nco

Fig. 17

Number of control outputs Nco

Time of test when using the semi-sequential ics (ms)

*Fig. 18*

Input filter

Td1, Td2 = Delay time of input filter

reading

Td1, Td2 = Delay time of input filter

*Fig. 13*

EP 0 864 875 B1

# Fig. 20

| CYCLE 1 Safety taks process | CYCLE 2 short circuit test | CYCLE 3 Safety taks process | CYCLE 4 interface test | CYCLE 5 Safety taks process | CYCLE 6 short circuit test |
|---|---|---|---|---|---|

$Ti = 4ms$

CO1-12

Input signal (stop order)

Signal after the input filter

Reading inputs in safety task process

Signal read by the µP

$Tp$ =Processing time of the input data = ~2ms

Output command

Output safety circuit

closed

opened

$Tf$ ~2ms

$Tc$ ~10ms (2Ti +Tp)

$Td$ ~7ms

Max. reaction time = ~19ms

Tf = Delay time of the input filter

Tc = Cycle time

Td = Deactivation time of the relay

Tp = Processing time of the input data

EP 0 864 875 B1

*Fig. 21*

Tc = Cycle time

Td = Deactivation time of the relay

Tf = Delay time of the input filter

## Fig. 22

| CYCLE 1 | CYCLE 2 | CYCLE 3 | CYCLE 4 | CYCLE 5 | CYCLE 6 |
|---|---|---|---|---|---|
| short circuit test default ? | safety task process | interface test | safety task process | short circuit test | safety task process |

Interrupts

$Ti = 4ms$

COI-I2

Input signal E1

Input signal E2

Signal X1

Signal X2

Short circuit test

Reading inputs
in safety task process

Signal X1 read by the μP

Signal X2 read by the μP

Output command

Processing time of the input data: $Tp = 2ms$

Output safety circuit      closed

opened

Tf
~2ms

Tc
$=Ti+Tp = 6ms$

Td
~ 7ms

Reaction time = ~15ms

Tc = Cycle time

Td = Deactivation time of the relay

Tf = Delay time of the input filter

EP 0 864 875 B1

## Fig. 23